# FASCICULE DE BREVET EUROPEEN

(11) **EP 0 445 017 B1**
(45) Date de publication et mention de la délivrance du brevet: **06.09.1995**
(21) Numéro de dépôt: 91400505.3
(22) Date de dépôt: 25.02.1991
(51) Int. Cl.: H01P 7/04, G01R 33/30

(54) **Résonateur coaxial à capacité d'accord répartie**
Koaxialer Resonator mit verteilter Abstimmkapazität
Coaxial resonator with distributed tuning capacity

(30) Priorité: 26.02.1990 FR 9002347
(43) Date de publication de la demande: 04.09.1991
(73) Titulaire: COMMISSARIAT A L'ENERGIE ATOMIQUE, 75015 Paris (FR)
(72) Inventeur: Glenat, Henri, F-38700 Corenc (FR); Kernevez, Nelly, F-38000 Grenoble (FR)
(74) Mandataire: Signore, Robert

(56) Documents cités:
- FR-A- 2 092 998
- FR-A- 2 098 624
- GB-A- 627 340
- US-A- 4 717 880
- JOURNAL OF PHYSICS E. SCIENTIFIC INSTRUMENTS. vol. 2, no. 12, décembre 1969,ISHING, Bristol,GB;pages 1036 - 1040; M.DECORPS et al.: "Etude comparative de divers types de volumes résonants pour spectromètres à résonance paramagnétique électronique..."
- ELECTRONIC COMPONENTS AND APPLICATIONS vol.6, no.2, 1984, Eindhoven,NL;pages 83 - 86; H.FIEDELDY: "VHF power amplifiers with broadband input circuitry"

## Description

La présente invention a pour objet un résonateur coaxial à capacité d'accord répartie. Un tel résonateur peut être utilisé dans les sondes de magnétomètres à résonance magnétique nucléaire (RMN en abrégé). Un des domaines d'application de l'invention est donc la mesure des champs magnétiques, notamment du champ magnétique terrestre. Mais le résonateur de l'invention peut être utilisé dans d'autres appareils.

Lorsqu'il est utilisé dans une sonde à RMN, le résonateur de l'invention l'est de la manière décrite notamment dans les demandes de brevets français FR-A-1 447 226 et FR-A-2 098 624. Il n'est donc pas utile de décrire en détail cet appareil. Il suffit de rappeler que la sonde comprend un ou plusieurs flacons contenant un échantillon liquide (dit aussi "solution radicalaire"), ces flacons étant disposés dans un résonateur coaxial. Ce résonateur est constitué d'un conducteur central traversant le ou les flacon(s) et un conducteur extérieur situé autour du ou des flacon(s). La sonde comprend des enroulements de prélèvement et de réinjection d'un signal à la fréquence de LARMOR. Cette fréquence est définie, par le champ magnétique dans lequel baigne la sonde et par le rapport gyromagnétique propre à l'échantillon liquide utilisé.

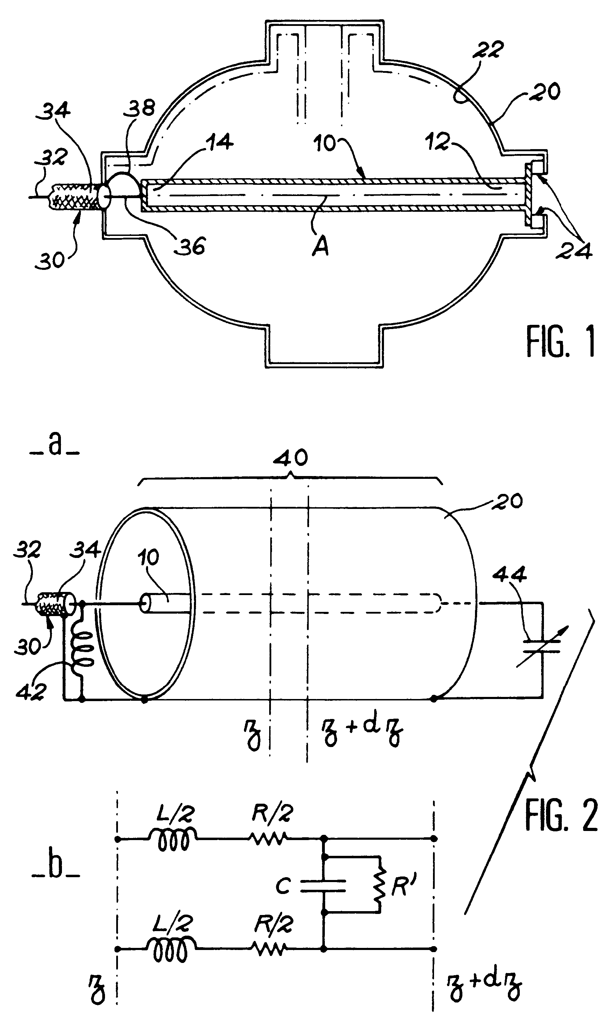

Un résonateur pour sonde RMN selon l'art antérieur est représenté sur la figure 1 annexée. Tel que représenté, il comprend :
- un conducteur central 10 ayant la forme d'un cylindre circulaire d'axe A, avec une première extrémité 12 et une seconde extrémité 14 ;
- un conducteur extérieur 20, de révolution autour de l'axe A et constitué par une couche conductrice déposée sur la paroi extérieure des flacons 22 contenant la solution radicalaire, la couche conductrice étant généralement divisée en secteurs ;
- des condensateurs d'accord 24, connectés entre la première extrémité 12 du conducteur central 10 et le conducteur extérieur 20.

Ce résonateur est alimenté par un câble coaxial 30, ayant une âme centrale 32 et une gaine conductrice extérieure 34 telle qu'une tresse ; la gaine est reliée au conducteur extérieur 20 et l'âme 32 à la seconde extrémité 14 du conducteur central par un prolongement 36 ; par ailleurs, cette extrémité 14 est reliée à son tour à la tresse par une boucle 38, généralement constituée par un fil d'argent.

Ce résonateur fonctionne de la manière suivante. L'énergie radiofréquence est apportée par le câble coaxial 30. La fréquence de résonance est ajustée par les condensateurs 24. Le conducteur central 10 constitue un point "chaud" (du point de vue du potentiel) et le conducteur extérieur 20 un point "froid". L'adaptation d'impédance entre le câble coaxial (dont l'impédance est en général de 50 Ohms) et le résonateur est obtenu par la boucle 38, qui se comporte comme une inductance réglable disposée en court-circuit à l'extrémité du câble coaxial.

Le schéma électrique équivalent de l'ensemble est représenté sur la figure 2 annexée. Ce schéma montre, sur la partie (a), un résonateur 40 avec une boucle d'adaptation 42 et un condensateur d'accord 44. Le résonateur 40 est à impédances réparties selon l'axe z. Cela signifie qu'entre la cote z et la cote z+dz, une tranche élémentaire du résonateur équivaut au circuit de la partie (b), avec deux inductances L/2, deux résistances R/2, un condensateur C avec une résistance R′ en parallèle, les valeurs L, C et R, R′ étant fonctions de la géométrie du résonateur (donc de z) ainsi que des éléments diélectriques qu'il contient.

Bien que donnant satisfaction à certains égards, de tels résonateurs présentent des inconvénients, essentiellement liés à la présence du ou des condensateurs de réglage (24 sur la figure 1 et 44 sur le schéma de la figure 2a). Ces inconvénients sont les suivants :
- il est difficile de trouver des condensateurs offrant toutes les conditions requises dans cette application : bonne qualité en haute fréquence, absence d'effet redresseur, bonne tenue en tension, amagnétisme, facilité de réglage, etc... ;
- on observe un fort rayonnement à très haute fréquence au niveau des condensateurs, sauf à blinder ceux-ci ;
- la bulle de dilatation, qui est inévitablement présente dans les flacons, peut venir se placer au niveau des condensateurs de réglage et désaccorder le résonateur ;
- les différences (de l'ordre de ± 10%) entre les capacités des différents condensateurs d'accord entraînent des différences d'intensité dans les courants circulant dans les secteurs du conducteur extérieur auxquels ils sont reliés et, par conséquent, des pertes par rayonnement.

On connaît encore, par le document US-A-4,717,880, un spectromètre à résonance de spin électronique (ESR) qui comprend un résonateur en anneau fendu. Un conducteur intérieur est pourvu d'une fente et un échantillon est placé dans ce conducteur intérieur sur l'axe. Des moyens sont prévus pour concentrer les lignes de champ électrique dans la fente. Ces moyens sont constitués par un écran conducteur plus large que la fente. Le résonateur peut être accordé en déplaçant l'écran devant la fente pour la dégager plus ou moins.

Ce type de résonateur ne convient pas aux magnétomètres à RMN où l'échantillon doit être placé dans la cavité résonnante, entre les deux conducteurs. Par ailleurs, les problèmes énumérés plus haut ne se posent pas dans un spectromètre à ESR. Ce document n'est donc d'aucun secours pour résoudre les problèmes techniques propres aux magnétomètres à RMN.

La présente invention a justement pour but de remédier à ces inconvénients. A cette fin, elle propose un résonateur coaxial pour sonde de magnétomètre à résonance, ce résonateur comprenant un conducteur extérieur et un conducteur central ayant tous deux un même axe, et un condensateur réglable dont la capacité est répartie le long de l'axe du résonateur, ce résonateur étant apte à recevoir au moins un échantillon, ce résonateur étant caractérisé par le fait que l'échantillon est disposé entre le conducteur extérieur et le conducteur central et que le condensateur comprend au moins deux armatures conductrices déposées sur au moins deux cylindres isolants non fendus et emboîtés l'un dans l'autre, l'une des deux armatures constituant l'un des deux conducteurs du résonateur, l'emboîtement des cylindres l'un dans l'autre étant réglable.

Tous les inconvénients énumérés plus haut se trouvent alors éliminés :
- la réalisation d'excellents résonateurs (qualité en haute fréquence, absence d'effet redresseur, bonne tenue en tension, amagnétisme) est simple ; quant au réglage, il s'obtient simplement en faisant glisser l'une des armatures par rapport à l'autre ;
- le rayonnement en bout de résonateur est supprimé ;
- le désaccord dû au déplacement de la bulle de dilatation est évité puisque la bulle affecte la valeur de la capacité d'une manière indépendante de sa position ;
- l'égalité (à 0,5% près) entre les différentes capacités partielles de la capacité répartie assure la symétrie des courants circulant dans les secteurs du conducteur extérieur et, par conséquent, L'absence de rayonnement.

En plus de ces qualités, il faut souligner que le type de condensateur utilisé permet de faire fonctionner le résonateur à des fréquences plus élevées que dans l'art antérieur, par exemple au-delà de 300 MHz. Par ailleurs, il existe une grande variété de modes de réalisation des armatures (à bandes, à spirales, ..., etc.), qui peut, dans certains cas, s'avérer utile.

De façon précise, la présente invention a pour objet un résonateur coaxial pour sonde de magnetomètre à résonance comprenant un conducteur extérieur et un conducteur central ayant tous deux une symétrie de révolution autour d'un même axe, et un condensateur d'accord, dont la capacité est répartie le long de l'axe du résonateur, ce résonateur étant apte à recevoir au moins un échantillon, ce résonateur étant caractérisé par le fait que l'échantillon est disposé entre le conducteur extérieur et le conducteur central et que le condensateur comprend au moins deux armatures conductrices (50, 60, 62, 72, 80, 82, 84) déposées sur au moins deux cylindres isolants (50, 56, 62, 110, 113) emboîtés l'un dans l'autre, l'une des deux armatures (58, 82) constituant l'un des deux conducteurs du résonateur, l'emboîtement des cylindres l'un dans l'autre étant réglable.

Selon un mode de réalisation avantageux, le condensateur comprend une première armature constituée par un premier tube isolant recouvert extérieurement d'une première couche conductrice et une deuxième armature comprenant un deuxième tube isolant emboîté dans le premier et recouvert extérieurement d'une seconde couche conductrice, l'un des tubes pouvant être déplacé par exemple manuellement par rapport à l'autre.

Selon un autre mode de réalisation, le condensateur comprend, en outre, une troisième armature constituée par un noyau isolant recouvert d'une troisième couche conductrice, ce noyau étant emboîté dans le deuxième tube.

Selon encore un autre mode de réalisation, le condensateur est réparti tout le long du conducteur extérieur du résonateur, l'une des armatures du condensateur constituant ce conducteur extérieur.

De toute façon, les caractéristiques et avantages de l'invention apparaîtront mieux à la lumière de la description qui va suivre. Cette description porte sur des exemples de réalisation donnés à titre explicatif et nullement limitatif, et se réfère à des dessins annexés sur lesquels :
- la figure 1, déjà décrite, montre un résonateur pour sonde à RMN selon l'art antérieur ;
- la figure 2, déjà décrite, montre le schéma électrique équivalent d'un résonateur selon l'art antérieur ;
- la figure 3 montre, selon un premier mode de réalisation, trois éléments d'un condensateur selon l'invention ;
- la figure 4 montre le mode de connexion avec les secteurs extérieurs du résonateur dans ce premier mode de réalisation ;
- la figure 5 montre, selon un second mode de réalisation, trois éléments d'un condensateur selon l'invention ;
- la figure 6 montre les connexions avec les secteurs extérieurs du résonateur dans ce mode de réalisation ;
- la figure 7 montre schématiquement, en coupe, un résonateur selon l'invention équipé d'un condensateur réparti le long du conducteur central ;
- la figure 8 montre un schéma électrique équivalent d'un résonateur selon l'invention ;
- la figure 9 montre un troisième mode de réalisation à un seul tube isolant ;
- la figure 10 montre un mode de réalisation à surépaisseur ;
- la figure 11 montre un autre mode de réalisation à surépaisseur ;
- la figure 12 montre une variante d'armature à bandes spiralées ;
- la figure 13 illustre un mode de réalisation dans lequel le condensateur est réparti à la périphérie du résonateur.

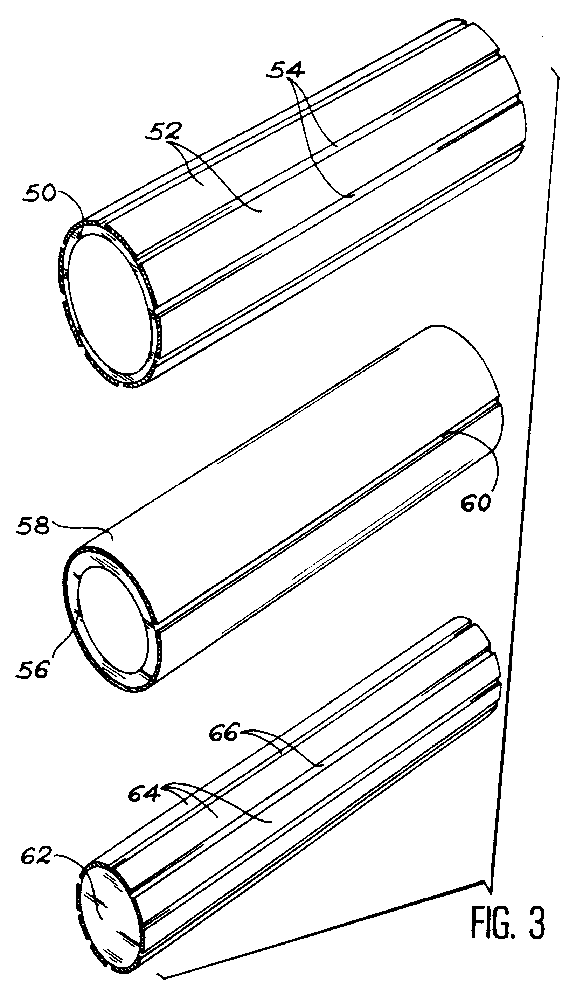

La figure 3 montre trois éléments permettant de réaliser un condensateur selon un premier mode de réalisation. Ces éléments sont constitués par :
- un premier tube isolant 50 recouvert extérieurement d'une première couche conductrice formée de bandes 52 électriquement séparées les unes des autres par des intervalles 54,
- un deuxième tube isolant 56 recouvert d'une deuxième couche conductrice 58 coupée par un intervalle 60,
- un noyau central 62 recouvert d'une troisième couche conductrice formée de bandes 64 séparées par des intervalles 66.

Le noyau 62 est emboîté dans le tube 56, lequel est emboîté dans le tube 50. On obtient ainsi un double condensateur avec trois armatures, l'armature centrale étant constituée par le conducteur 58 sur le tube 56.

Dans ce mode de réalisation, les tubes isolants peuvent être en quartz, pyrex, macor (marques déposées), etc... Leur usinage est assuré au centième de millimètre. On peut aussi les réaliser en porcelaine par moulage.

Les couches conductrices peuvent être obtenues par dépôt de peinture d'argent directement étalée sur la surface extérieure des tubes et sur le noyau central, et par recuit vers 550°C. L'épaisseur de la couche conductrice est d'environ 2/100 mm.

On peut encore obtenir de tels tubes en déposant un matériau conducteur sur un isolant plat (par exemple en mica), en gravant ce conducteur pour obtenir des bandes, puis en enroulant l'ensemble pour obtenir un tube au diamètre désiré. On peut aussi coller des bandes conductrices sur un tube isolant.

A titre purement explicatif, on peut avoir un premier tube 50 de diamètre extérieur 18 mm, de diamètre intérieur 16 mm et de longueur 105 mm, avec 6 à 8 bandes conductrices espacées d'un millimètre. Le second tube 56 peut avoir un diamètre extérieur de 15,9 mm, un diamètre intérieur de 13,9 mm et une longueur de 102 mm avec un espace d'un millimètre interrompant la couche conductrice. Enfin, le noyau 62 peut posséder un diamètre de 13,8 mm et une longueur de 102 mm. Il peut comprendre 6 ou 8 bandes espacées de 1 mm chacune. Par coulissage dans le tube 56, il permet de régler la valeur de la capacité totale.

Ainsi constitué, le condensateur comprend deux ensembles de condensateurs, disposés en parallèle :
- un premier ensemble constitué par les bandes 52 du premier tube et la bande 58 du second ; dans l'exemple donné plus haut, chacun de ces condensateurs a une capacité fixe de 13 pF ;
- un second ensemble formé par les bandes 64 du noyau 62 et la couche 58 du second tube ; dans l'exemple donné plus haut, les capacités varient entre 0 (noyau complétement retiré) et 3 pF (noyau complétement enfoncé).

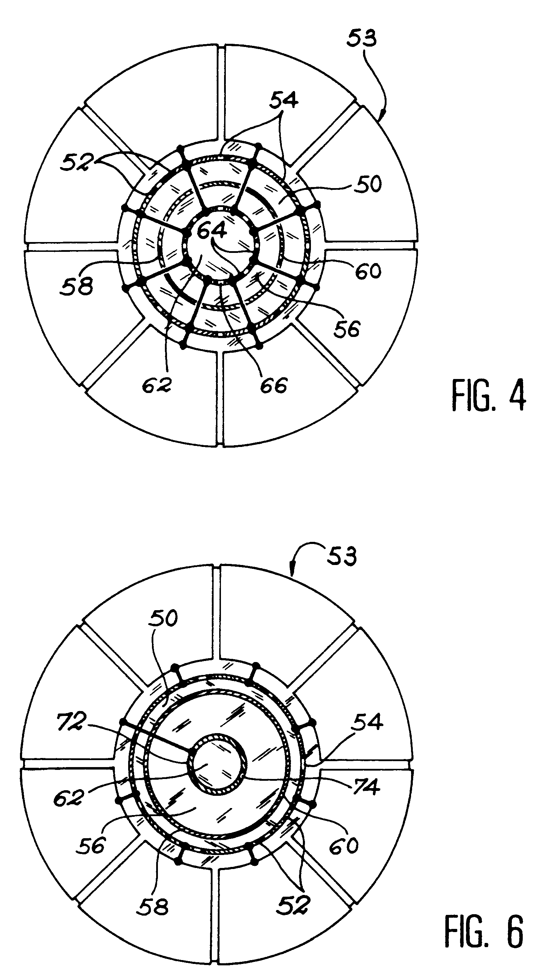

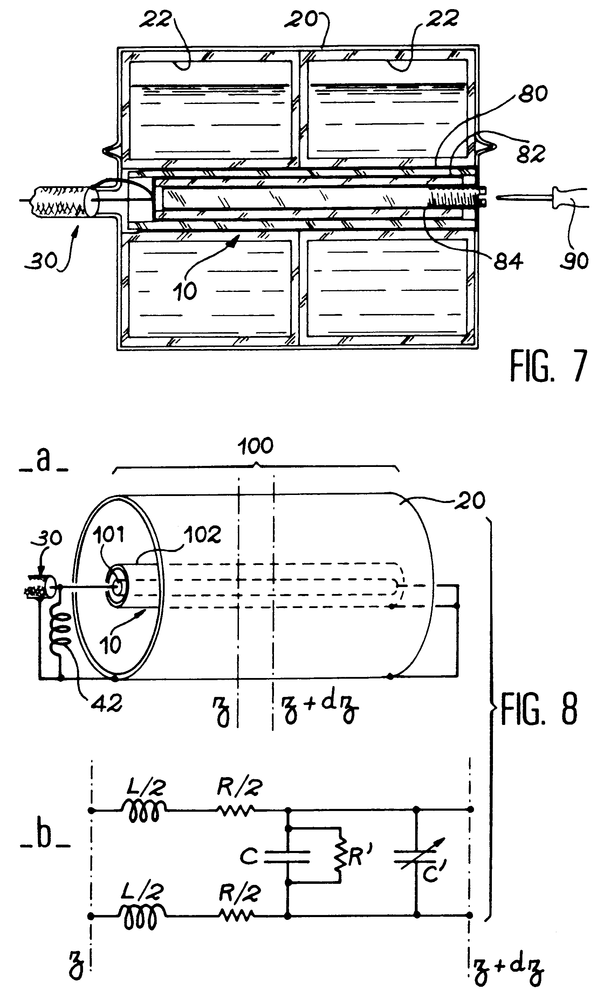

Les connexions entre ces diverses bandes et les secteurs du conducteur extérieur sont représentées sur la figure 4. Chacune des huit bandes 52 est reliée à l'une des huit bandes 64 et à l'un des huit secteurs 53 du conducteur extérieur. Le conducteur 58 du tube central n'est pas relié au conducteur extérieur mais à l'âme du câble coaxial d'alimentation (ce qui apparaîtra mieux sur la figure 7).

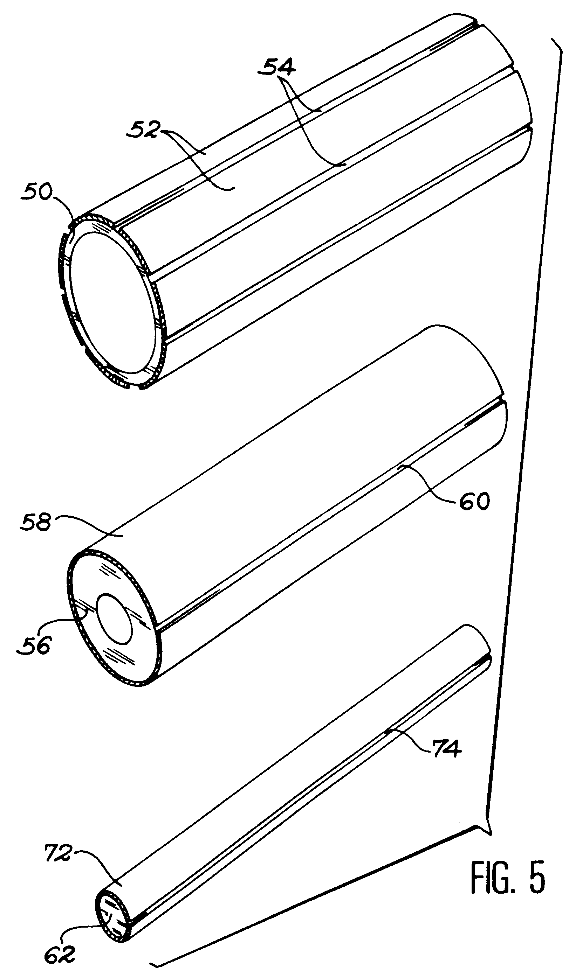

Un autre mode de réalisation du condensateur et représenté sur la figure 5. On retrouve le premier tube 50 de la figure 3 et ses bandes conductrices 52, à la différence près qu'il n'y a que N-1 bandes, au lieu de N, si N est le nombre de secteurs 53 du conducteur extérieur (il n'y aura donc, par exemple, que 7 bandes au lieu de 8). On retrouve également le noyau 62, à la différence près qu'il n'y a qu'une seule bande 72 (au lieu de 8) interrompue par un intervalle 74. Il n'existe plus alors qu'un seul condensateur variable, à savoir celui dont les armatures comprennent les couches 58 et 72. La capacité varie alors entre 0 et 16 pF.

Le mode d'interconnexion est alors modifié comme indiqué sur la figure 6. Sept des secteurs 53 sont reliés aux sept bandes 52 du tube extérieur et le huitième est relié au conducteur unique 72 du noyau.

La figure 7 montre, en coupe, un résonateur coaxial équipé d'un condensateur réparti le long du conducteur central. On retrouve les éléments déjà représentés sur la figure 1, à savoir les flacons 22 (qui n'ont plus ici la forme hémisphérique mais une forme cylindrique), le conducteur extérieur 20, le conducteur central 10 et le câble coaxial d'alimentation 30. Selon l'invention, le conducteur central 10 est constitué par une des armatures emboîtées les unes dans les autres, soit 80, 82, 84 et de préférence par 82. Les armatures 80 et 84 sont connectées au conducteur extérieur 20 comme illustré sur les figures 4 et 6 déjà décrites et l'armature centrale 82 est reliée à l'âme du câble d'alimentation 30, l'adaptation s'effectuant toujours par une boucle.

Le réglage de la capacité totale peut s'effectuer en ajustant l'enfoncement du noyau, par exemple par rotation au moyen d'un tourne-vis 90 si un filetage a été prévu entre le noyau et l'armature 82 dans lequel il est emboîté.

Il faut observer, à ce stade de la description de l'invention, que l'on connaît déjà des condensateurs cylindriques réglables formés de deux armatures cylindriques emboîtées plus ou moins l'une dans l'autre. Le document de brevet français FR-A-2 092 998 décrit un tel condensateur, en particulier, pour les magnétomètres à RMN. La présente invention se distingue de cet art antérieur moins par la structure en soi du condensateur que par son agencement dans le résonateur complet. Ce point peut être souligné grâce à la figure 8, qui montre le schéma électrique équivalent d'un résonateur selon l'invention.

Sur cette figure, on voit (partie (a)) le résonateur 100 avec un conducteur central 10, un conducteur extérieur 20. Ce résonateur est relié à une inductance d'adaptation 42. A cet égard, le schéma est celui-là même de la figure 2 partie (a). Mais à la différence de l'art antérieur, on ne trouve plus de condensateur réglable en bout de résonateur tel que 44 sur la figure 2, mais un condensateur réparti tout le long du conducteur central (armatures 101 et 102). La partie (b) de la figure 8 montre le schéma électrique équivalent d'une tranche élémentaire de ce résonateur entre les cotes z et z+dz. On y retrouve, comme sur la partie (b) de la figure 2, les inductances réparties L/2, les résistances réparties R/2, le condensateur réparti C avec sa résistance en parallèle R′ ; mais le schéma de la figure 8 offre cette particularité de présenter un condensateur réglable réparti C′. Dans le dispositif du document FR-A-2 092 998 le condensateur cylindrique est placé en bout de résonateur, comme dans le schéma de la partie (a) de la figure 2 (référence 44). On retrouve donc, avec cette structure antérieure, tous les inconvénients énoncés plus haut, auxquels l'invention remédie grâce à la répartition du condensateur d'accord.

On soulignera encore, à propos du condensateur du document FR-A-2 092 998 que, lorsqu'il est utilisé dans une sonde, ce condensateur est placé en bout de sonde, comme le condensateur 24 de la figure 1 de la présente demande. C'est un composant qu'on trouve dans le commerce et que l'on dispose là où il est utile. Ce condensateur n'est pas réparti le long de l'axe et l'une de ses armatures ne constitue pas le conducteur central d'un résonateur.

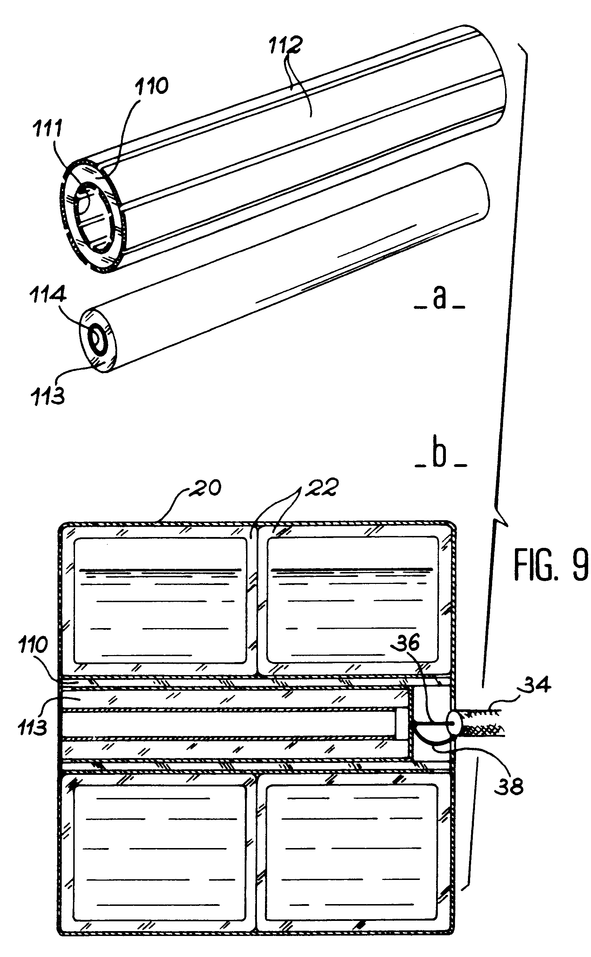

Les figures 9 à 13 montrent d'autres modes de réalisation du résonateur de l'invention.

Sur la figure 9 tout d'abord, on voit (partie a) un tube isolant 110 recouvert extérieurement d'une couche conductrice 112 et intérieurement d'une couche conductrice 111, toutes deux en forme de bandes. L'accord est obtenu par introduction d'un noyau 113 recouvert intérieurement d'une couche conductrice 114.

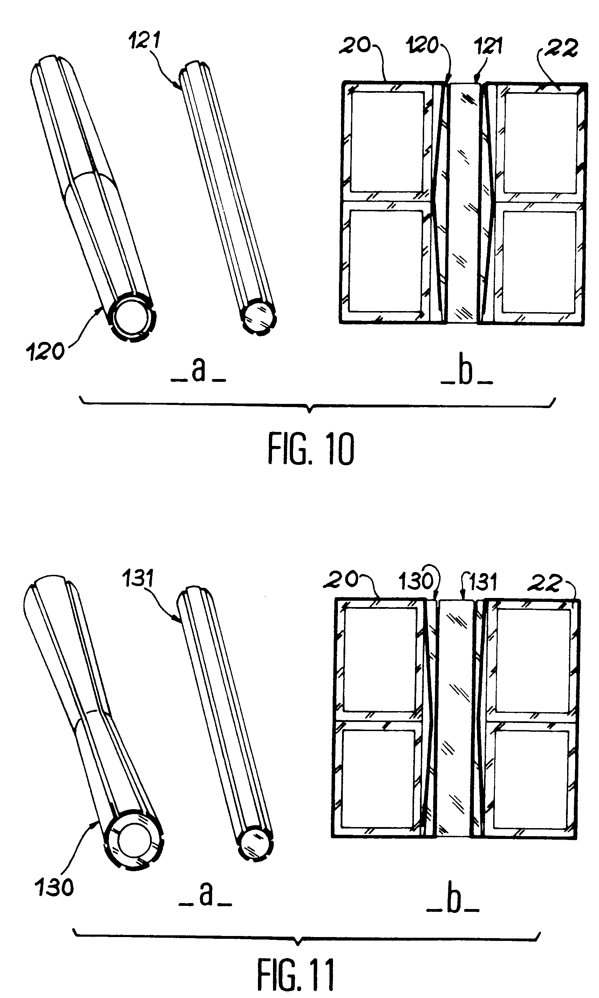

Sur les figures 10 et 11, le tube extérieur ne présente pas la même épaisseur sur toute sa longueur, de sorte que la capacité répartie varie le long de l'axe du résonateur. Sur la figure 10, partie a, le tube 120 est plus épais en son milieu qu'à ses extrémités tandis que, sur la figure 11, partie a, le tube 130 est plus mince en son milieu qu'à ses extrémités. Dans les deux cas, il est prévu un tube intérieur respectivement 121 et 131 (constituant par exemple le conducteur central).

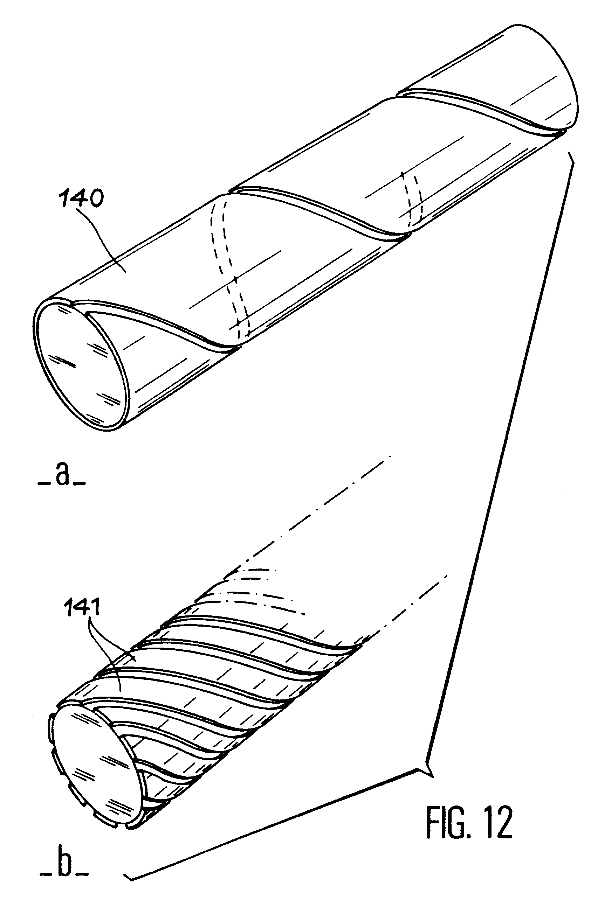

La figure 12 montre deux variantes où la couche conductrice extérieure présente la forme de bandes hélicoïdales larges 140 (partie a) ou étroites 141 (partie b).

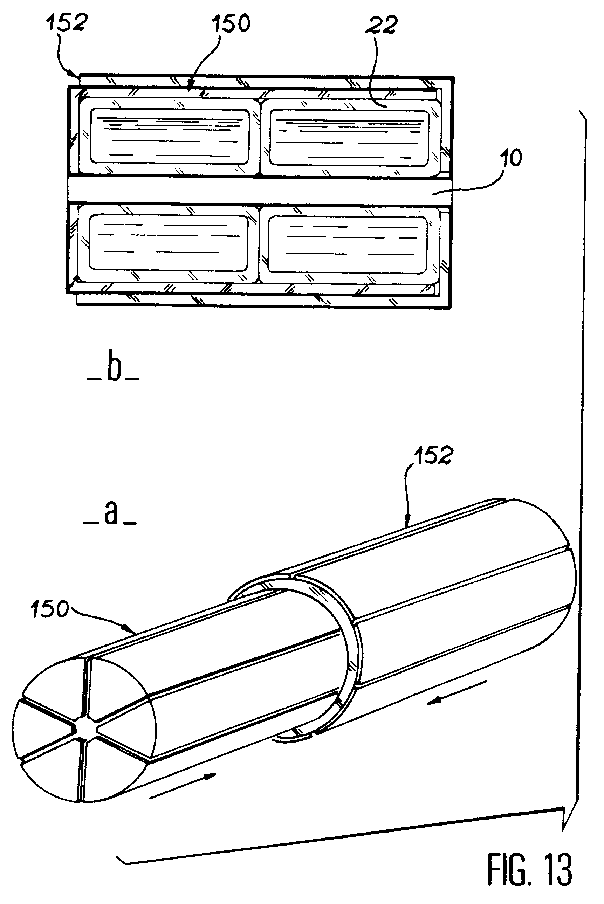

Enfin, la figure 13 montre un mode de réalisation où le condensateur de réglage est disposé à l'extérieur du résonateur. Ce condensateur comprend, par exemple, deux tubes 150 et 152 emboîtés l'un dans l'autre et recouverts de bandes conductrices (le conducteur central 10 étant constitué de façon classique).

## Revendications

1. Résonateur coaxial pour sonde de magnétomètre à résonance, ce résonateur comprenant un conducteur extérieur (20) et un conducteur central (10) ayant tous deux un même axe (A), et un condensateur réglable dont la capacité (24, 44) est répartie le long de l'axe du résonateur, ce résonateur étant apte à recevoir au moins un échantillon, ce résonateur étant caractérisé par le fait que l'échantillon est disposé entre le conducteur extérieur et le conducteur central et que le condensateur comprend au moins deux armatures conductrices (50, 60, 62, 72, 80, 82, 84) déposées sur au moins deux cylindres isolants (50, 56, 62, 110, 113) emboîtés l'un dans l'autre, l'une des deux armatures (58, 82) constituant l'un des deux conducteurs du résonateur, l'emboîtement des cylindres l'un dans l'autre étant réglable.

2. Résonateur coaxial selon la revendication 1, caractérisé par le fait que l'une des armatures (58, 82) du condensateur constitue le conducteur central (10) du résonateur.

3. Résonateur coaxial selon la revendication 1, caractérisé par le fait que le condensateur d'accord comprend une première armature constituée par un premier tube isolant (50) recouvert extérieurement d'une première coche conductrice (52) et une deuxième armature comprenant un deuxième tube isolant (56) emboîté dans le premier et recouvert extérieurement d'une seconde couche conductrice (58).

4. Résonateur coaxial selon la revendication 3, caractérisé par le fait que le condensateur d'accord comprend en outre une troisième armature constituée par un noyau isolant (62) recouvert d'une troisième couche conductrice (64), ce noyau étant emboîté dans le deuxième tube (56).

5. Résonateur coaxial selon la revendication 3, caractérisé par le fait que, le conducteur extérieur (20) du résonateur étant divisé en une pluralité de N secteurs conducteurs (53) isolés électriquement les uns des autres, la première couche conductrice (52) de la première armature du condensateur est formée d'une pluralité de N bandes conductrices (52) électriquement isolées les unes des autres (54), chacun des N secteurs (53) étant électriquement relié à l'une des N bandes (52) de la première couche conductrice, la deuxième couche conductrice (58) de la deuxième armature constituant le conducteur intérieur (10) du résonateur.

6. Résonateur coaxial selon la revendication 4, caractérisé par le fait que, le conducteur extérieur (20) du résonateur étant divisé en une pluralité de N secteurs conducteurs (53) isolés électriquement les uns des autres, la première couche conductrice (52) de la première armature du condensateur ainsi que la troisième couche conductrice (64) de la troisième armature sont formées chacune d'une pluralité de N bandes conductrices (52, 64) électriquement isolées les unes des autres (54, 66), chacun des secteurs (53) du conducteur extérieur (20) étant électriquement relié à une bande (52) de la première armature et à une bande (64) de la troisième armature, la deuxième couche conductrice (58) de la deuxième armature constituant le conducteur intérieur du résonateur.

7. Résonateur coaxial selon la revendication 4, caractérisé par le fait, que le conducteur extérieur du résonateur étant formé de N secteurs conducteurs (53) isolés électriquement les uns des autres, la première couche conductrice de la première armature est formée de N-1 bandes conductrices (52) isolées électriquement les unes des autres, ces N-1 bandes étant reliées à N-1 secteurs conducteurs (53) du conducteur extérieur (20) du résonateur, le N^{ième} secteur étant relié à la troisième couche conductrice (72) de la troisième armature du condensateur, la deuxième couche conductrice (58) de la deuxième armature constituant le conducteur central (10) du résonateur.

8. Résonateur coaxial selon la revendication 1, caractérisé par le fait que le condensateur comprend un tube isolant (110) recouvert sur sa face intérieure par une première couche conductrice (111) et sur sa face extérieure par une seconde couche conductrice (112) et un noyau cylindrique (113) isolant recouvert intérieurement d'une couche conductrice (114).

9. Résonateur coaxial selon la revendication 3, caractérisé par le fait que le premier tube isolant présente une épaisseur qui n'est pas la même au milieu du tube qu'aux deux extrémités.

10. Résonateur coaxial selon la revendication 9, caractérisé par le fait que que le premier tube isolant (120) est plus mince au milieu qu'aux extrémités.

11. Résonateur coaxial selon la revendication 9, caractérisé par le fait que le premier tube isolant (130) est plus épais au milieu qu'aux extrémités.

12. Résonateur coaxial selon l'une quelconque des revendications précédentes, caractérisé par le fait que l'une au moins des couches conductrices est en forme de bandes conductrices (140) enroulées en hélice sur une âme isolante.

13. Résonateur coaxial selon la revendication 1, caractérisé par le fait que l'une des armatures (152) du condensateur constitue le conducteur extérieur du résonateur.

14. Résonateur coaxial selon l'une quelconque des revendications 1 à 13, caractérisé par le fait que l'un des cylindres supportant les armatures (84) est mobile par rapport à l'autre (80, 82), le condensateur d'accord ayant ainsi une capacité réglable.

## Patentansprüche

1. Koaxialer Resonator für eine Magnetometerresonanzsonde, wobei der Resonator einen äußeren Leiter (20) und einen mittigen Leiter (10) umfaßt, die alle beide die gleiche Achse (A) haben, und einen einstellbaren Kondensator, dessen Kapazität (24, 44) entlang der Resonatorachse aufgeteilt ist, wobei dieser Resonator wenigstens eine Probe aufnehmen kann und dieser Resonator **dadurch gekennzeichnet** ist, daß die Probe zwischen dem äußeren Leiter und dem mittigen Leiter angeordnet ist und daß der Kondensator wenigstens zwei leitende Belage (50, 60, 62, 72, 80, 82, 84) umfaßt, die auf wenigstens zwei isolierenden Zylindern (50, 56, 62, 110, 113) abgesetzt sind, die ineinandergesteckt sind, wobei einer der zwei Belage (58, 82) einen der zwei Leiter des Resonators bildet, wobei das Einstecken der Zylinder ineinander einstellbar ist.

2. Koaxialer Resonator gemäß Anspruch 1, **dadurch gekennzeichnet**, daß einer der Kondensatorbelage (58, 82) den mittigen Leiter (10) des Resonators bildet.

3. Koaxialer Resonator gemäß Anspruch 1, **dadurch gekennzeichnet**, daß der Abstimmkondensator einen ersten Belag umfaßt, der von einem ersten, isolierenden Rohr (50) gebildet ist, das außen mit einer ersten, leitenden Schicht (52) überdeckt ist, und einen zweiten Belag, der ein zweites, isolierendes Rohr (56) umfaßt, das in das erste hineingesteckt ist und außen mit einer zweiten, leitenden Schicht (58) überdeckt ist.

4. Koaxialer Resonator gemäß Anspruch 3, **dadurch gekennzeichnet**, daß der Abstimmkondensator ferner einen dritten Belag umfaßt, der von einem isolierenden Kern (62) gebildet wird, der mit einer dritten, leitenden Schicht (64) überzogen ist, wobei dieser Kern in das zweite Rohr (56) hineingesteckt ist.

5. Koaxialer Resonator gemäß Anspruch 3, **dadurch gekennzeichnet**, daß der äußere Leiter (20) des Resonators in eine Vielzahl von N Leiterabschnitten (53) unterteilt ist, die elektrisch voneinander isoliert sind, die erste, leitende Schicht (52) des ersten Kondensatorbelags aus einer Vielzahl von N Leiterbändern (52) gebildet ist, die elektrisch voneinander (54) isoliert sind, jeder der N Abschnitte (53) elektrisch mit einem der N Bänder (52) der ersten, leitenden Schicht verbunden ist, wobei die zweite, leitende Schicht (58) des zweiten Belags den inneren Leiter (10) des Resonators bildet.

6. Koaxialer Resonator gemäß Anspruch 4, **dadurch gekennzeichnet**, daß der äußere Leiter (20) des Resonators in eine Vielzahl von N Leiterabschnitte (53) unterteilt ist, die elektrisch voneinander isoliert sind, die erste, leitende Schicht (52) des ersten Kondensatorbelags sowie die drittte, leitende Schicht (64) des dritten Belags jeweils von einer Vielzahl von N Leiterbändern (52, 64) gebildet sind, die elektrisch voneinander (54, 66) isoliert sind, jeder der Abschnitte (53) des äußeren Leiters (20) elektrisch mit einem Band (52) des ersten Belags und einem Band (64) des dritten Belags verbunden ist, wobei die zweite, leitende Schicht (58) des zweiten Belags den inneren Leiter des Resonators bilden.

7. Koaxialer Resonator gemäß Anspruch 4, **dadurch gekennzeichnet**, daß der äußere Leiter des Resonators von N Leiterabschnitten (53) gebildet ist, die voneinander elektrisch isoliert sind, die erste, leitende Schicht des ersten Belags von N-1 Leiterbändern (52) gebildet ist, die elektrisch voneinander isoliert sind, diese N-1 Bänder mit N-1 Leiterabschnitten (53) des äußeren Leiters (20) des Resonators verbunden sind, der N-te Abschnitt mit der dritten, leitenden Schicht (72) des dritten Kondensatorbelags verbunden ist, die zweite, leitende Schicht (58) des zweiten Belags den mittigen Leiter des Resonators bilden.

8. Koaxialer Resonator gemäß Anspruch 1, **dadurch gekennzeichnet**, daß der Kondensator ein isolierendes Rohr (110) umfaßt, das auf seiner Innenseite mit einer ersten, leitenden Schicht (111) und auf seiner Außenseite mit einer zweiten, leitenden Schicht (112) überdeckt ist, und einen isolierenden, zylindrischen Kern (113), der innen mit einer leitenden Schicht (114) überdeckt ist.

9. Koaxialer Resonator gemäß Anspruch 3, **dadurch gekennzeichnet**, daß das erste, isolierende Rohr eine Dicke aufweist, die nicht die gleiche in der Mitte des Rohrs wie an den zwei Enden ist.

10. Koaxialer Resonator gemäß Anspruch 9, **dadurch gekennzeichnet**, daß das erste, isolierende Rohr (120) in der Mitte dünner als an den Enden ist.

11. Koaxialer Resonator gemäß Anspruch 9, **dadurch gekennzeichnet**, daß das erste, isolierende Rohr (130) in der Mitte dicker als an den Enden ist.

12. Koaxialer Resonator gemäß einem der vorhergehenden Ansprüche, **dadurch gekennzeichnet**, daß wenigstens eine der leitenden Schichten in der Form von leitenden Bändern (140) ist, die als Spirale auf einen isolierenden Kern gewickelt sind.

13. Koaxialer Resonator gemäß Anspruch 1, **dadurch gekennzeichnet**, daß einer der Kondensatorbelage (152) den äußeren Leiter des Resonators bildet.

14. Koaxialer Resonator gemäß irgendeinem der vorhergehenden Ansprüche 1 bis 13, **dadurch gekennzeichnet**, daß einer der Zylinder, der die Belage (84) trägt, in bezug auf den anderen (80, 82) beweglich ist, der Abstimmkondensator somit eine einstellbare Kapazität hat.

## Claims

1. Coaxial resonator for a resonant magnetometer probe, said resonator comprising an external conductor (20) and a central conductor (10) both having the same axis (A), and a regulatable capacitor, whose capacitance (24,44) is distributed along the axis of the resonator, said resonator being able to receive at least one sample, characterized in that the sample is placed between the external conductor and the central conductor and that the capacitor has at least two conductive armatures (50,60,62,72,80,82,84) deposited on at least two insulating cylinders (50,56,62,110,113), which are not slit and which are fitted into one another, one of the two armatures (58,82) constituting one of the two conductors of the resonator, the fitting of the cylinders into one another being regulatable.

2. Coaxial resonator according to claim 1, characterized in that one of the capacitor armatures (58,82) constitutes the central conductor (10) of the resonator.

3. Coaxial resonator according to claim 1, characterized in that the tuning capacitor has a first armature constituted by a first insulating tube (50) externally covered by a first conductive layer (52) and a second armature comprising a second insulating tube (56) fitted into the first and externally covered by a second conductive layer (58).

4. Coaxial resonator according to claim 3, characterized in that the tuning capacitor also has a third armature constituted by an insulating core (62) covered by a third conductive layer (64), said core being fitted into the second tube (56).

5. Coaxial resonator according to claim 3, characterized in that, the external conductor (20) of the resonator being subdivided into a plurality of N conductive sectors (53) which are electrically insulated from one another, the first conductive layer (52) of the first capacitor armature being formed by a plurality of N conductive strips (52) electrically insulated from one another (54), each of the N sectors (53) being electrically connected to one of the N strips (52) of the first conductive layer, the second conductive layer (58) of the second armature constituting the internal conductor (10) of the resonator.

6. Coaxial resonator according to claim 4, characterized in that, the external conductor (20) of the resonator being subdivided into a plurality of N conductive sectors (53) electrically insulated from one another, the first conductive layer (52) of the first capacitor armature and the third conductive layer (64) of the third armature are each formed by a plurality of N conductive strips (52,64) electrically insulated from one another (54,66), each of the sectors (53) of the external conductor (20) being electrically connected to a strip (52) of the first armature and to a strip (64) of the third armature, the second conductive layer (58) of the second armature constituting the internal conductor of the resonator.

7. Coaxial resonator according to claim 4, characterized in that, the external conductor of the resonator being formed by N conductive sectors (53) electrically insulated from one another, the first conductive layer of the first armature is formed by N-1 conductive strips (52) electrically insulated from one another, said N-1 strips being connected to N-1 conductive sectors (53) of the external conductor (20) of the resonator, the nth sector being connected to the third conductive layer (72) of the third capacitor armature, the second conductive layer (58) of the second armature constituting the central conductor (10) of the resonator.

8. Coaxial resonator according to claim 1, characterized in that the capacitor has an insulating tube (110) covered on its inner face by a first conductive layer (111) and on its outer face by a second conductive layer (112) and an insulating cylindrical core (113) internally covered by a conductive layer (114).

9. Coaxial resonator according to claim 3, characterized in that the first insulating tube has a thickness which is not the same at the centre of the tube as at the two ends.

10. Coaxial resonator according to claim 9, characterized in that the first insulating tube (120) is thinner at the centre than at the ends.

11. Coaxial resonator according to claim 9, characterized in that the first insulating tube (130) is thicker at the centre than at the ends.

12. Coaxial resonator according to any one of the preceding claims, characterized in that at least one of the conductive layers is in the form of conductive strips (140) helically wound onto an insulating core.

13. Coaxial resonator according to claim 1, characterized in that one of the armatures (152) of the capacitor constitutes the external conductor of the resonator.

14. Coaxial resonator according to any one of the claims 1 to 13, characterized in that one of the cylinders supporting the armatures (84) is mobile with respect to the other (80,82) so that the tuning capacitor has a regulatable capacitance.
